**Europäisches Patentamt**

**European Patent Office**

**Office européen des brevets**

(11) Veröffentlichungsnummer: **0 076 292**
**B1**

(12) # EUROPÄISCHE PATENTSCHRIFT

(45) Veröffentlichungstag der Patentschrift:
16.07.86

(21) Anmeldenummer: **82901115.4**

(22) Anmeldetag: **08.04.82**

(86) Internationale Anmeldenummer:
**PCT/DE 82/00082**

(87) Internationale Veröffentlichungsnummer:
**WO 82/03723 (28.10.82 Gazette 82/26)**

(51) Int. Cl.⁴: **H 01 C 10/30, H 01 C 1/12, H 05 K 3/34, H 01 H 1/60, H 01 H 1/40**

(54) **ELEKTRISCHE KONTAKTVORRICHTUNG, INSBESONDERE FÜR MIT LEITERPLATTEN AUSGESTATTETE ELEKTRISCHE KLEINGERÄTE.**

(30) Priorität: **10.04.81 DE 3114607**

(43) Veröffentlichungstag der Anmeldung:
**13.04.83 Patentblatt 83/15**

(45) Bekanntmachung des Hinweises auf die Patenterteilung:
**16.07.86 Patentblatt 86/29**

(84) Benannte Vertragsstaaten:
**AT CH DE FR GB LI NL**

(56) Entgegenhaltungen:
**DE - A - 2 921 753**
**FR - A - 817 741**
**FR - A - 1 483 948**
**FR - A - 2 124 457**
**FR - A - 2 241 856**
**FR - A - 2 308 174**
**FR - A - 2 430 165**
**US - A - 3 610 811**
**US - A - 3 673 539**

(73) Patentinhaber: **Braun Aktiengesellschaft,
Rüsselsheimer Strasse 22, D-6000 Frankfurt/Main (DE)**

(72) Erfinder: **ROTH, Johann, Münchener Strasse 38,
D-8061 Schwabhausen (DE)**

(74) Vertreter: **Einsele, Rolf, Braun Aktiengesellschaft
Postfach 1120 Frankfurter Strasse 145, D-6242 Kronberg
Taunus (DE)**

**Beschreibung**

Die Erfindung betrifft ein Verfahren zur Herstellung eines insbesondere in elektrischen Kleingeräten, wie beispielsweise Uhren, Kameras und elektrischen Rasierapparaten verwendeten Leiterplatte, sowie auch eine Kontaktvorrichtung, die eine nach diesem Verfahren hergestellte Leiterplatte aufweist. Solche, beispielsweise aus Hartpapier bestehende Leiterplatten weisen Leiterbahnen auf, die vorzugsweise aus einer darauf aufgebrachten Kupferschicht durch die verschiedensten bekannten Verfahren herausgearbeitet werden können.

Zur Bestückung einer solchen Leiterplatte mit elektronischen Bauelementen werden diese zuerst auf einer der beiden Seiten (Unterseite) der Leiterplatte angebracht, dann werden die Zuleitungen durch im Leiterplattenkörper vorhandene Öffnungen zur Oberseite hindurch geführt und schliesslich werden die Zuleitungen in sogenannten Lötaugen verlötet, die auf der Oberseite der Leiterplatte um die vorgenannten Öffnungen herum aus den Leiterbahnen ausgebildet sind. Die dem Lot ausgesetzte Oberseite der Leiterplatte kann neben den Leiterbahnen auch Kontaktflächen aufweisen, wobei letztere jeweils aus einem Teilabschnitt einer Leiterbahn bestehen.

Durch das Verlöten der Zuleitungen von elektronischen Bauelementen in den Lötaugen der Leiterbahnen werden die Bauelemente mit den Leiterbahnen elektrisch und mit der Leiterplatte mechanisch verbunden. Dies geschieht im allgemeinen mit Hilfe von maschinellen Lötverfahren, beispielsweise mit dem Schwall- oder dem Schlepplötverfahren.

Auf der Oberseite solcher Leiterplatten können neben Leiterbahnen auch Widerstände mit verschiedenen Widerstandswerten aufgedruckt sein. Derartige aufgedruckte Widerstände, deren Widerstandswert vom verwendeten Material und den Abmessungen des Widerstands abhängt, können zum Beispiel mit sogenannten Widerstandspasten im Siebdruckverfahren aufgebracht werden.

Auf der Oberseite der Leiterplatte ausgebildete Kontaktflächen können Teil einer elektrischen Kontaktvorrichtung sein und von einem beweglichen Glied dieser Kontaktvorrichtung, beispielsweise einem Federblech oder einem Kontaktschleifer abgegriffen werden. Derartige Kontaktflächen sind in der Regel über der Kupferschicht zusätzlich noch vergoldet, um eine Verschlechterung der Leitfähigkeit durch Korrosion zu verhindern und damit eine sichere Kontaktgabe über einen möglichst langen Zeitraum zu gewährleisten. Es sind hierzu jedoch auch schon zusätzlich noch versilberte, vernickelte oder verzinnte Kontaktflächen eingesetzt worden. Derartige Leiterplatten sind recht aufwendig herzustellen, weil die verschiedenen Schichten der Kontaktflächen in mehreren galvanischen Bädern unter Abdeckung der restlichen Leiterplattenfläche aufgebracht werden müssen. Abgesehen davon, ist auch der reine Materialwert von Edelmetallschichten beträchtlich.

Dazuhin ist es bei solchen Leiterplatten erforderlich, die Kontaktflächen auf der Oberseite vor der Durchführung des maschinellen Lötvorganges durch geeignete Mittel abzudecken, um deren Verschmutzen durch anhaftendes Lot aus dem Lötbad zu verhindern. Nach dem Lötvorgang sind die Abdeckungen dann wieder zu entfernen.

Alle diese Verfahrensschritte machen die Herstellung einer Leiterplatte, die auf ihrer Oberseite sowohl Lötaugen zur Aufnahme der Zuleitungen elektronischer Bauteile, als auch einer Kontaktvorrichtung zugehöriger Kontaktflächen aufweist, relativ teuer.

Ein weiterer Nachteil der bekannten Kontaktvorrichtungen, die auf Leiterplatten angebrachte Kontaktflächen aufweisen, besteht darin, dass wiederum zur Vermeidung von Korrosion, auch die übrigen Kontaktflächen der Kontaktvorrichtung, die nicht auf Leiterbahnen angebracht sind, mit leitfähigen und korrosionsbeständigen Ummantelungen versehen werden müssen. Das Aufbringen dieser Ummantelungen kann auch wieder in galvanischen Bädern erfolgen, wobei wiederum die bereits vorstehend genannten Metalle Verwendung finden.

Grundsätzlich sind somit bei den bekannten Kontaktvorrichtungen, die auf Leiterplatten angebrachte Kontaktflächen aufweisen, alle Kontaktflächen mit korrosionsbeständigen Ummantelungen zu versehen. Weiterer gemeinsamer Nachteil aller bekannter derartiger Kontaktvorrichtungen, deren Kontaktflächen sich berühren und dabei gegeneinander verschoben werden, ist die Notwendigkeit, metallbeschichtete Kontaktflächen nachzufetten, da es sonst aufgrund von Korrosionserscheinungen zu Betriebsstörungen kommen kann, die einen vollständigen Ersatz der Kontaktvorrichtung und damit oftmals der ganzen Leiterplatte nötig machen.

Aufgabe der Erfindung ist es daher, ein Verfahren zur Herstellung einer Leiterplatte nach dem Oberbegriff des Patentanspruchs 1 anzugeben, welches die vorstehend angeführten Mängel nicht aufweist und bei dem insbesondere nicht die Notwendigkeit besteht, zum einen während der Galvanisierung die ganze Leiterplatte ausser den zu veredelnden Kontaktflächen und zum anderen während des maschinellen Lötvorgangs deren auf der Oberseite liegende Kontaktflächen abzudecken und die Abdeckung nach dem entsprechenden Vorgang jeweils wieder zu entfernen.

Gelöst wird diese Aufgabe gemäss der Erfindung dadurch, dass die auf der Oberseite der Leiterplatte liegenden Kontaktflächen nicht veredelt werden, sondern mit einer leitfähigen, korrosionsbeständigen, lotabweisenden und selbstschmierenden Ummantelung versehen werden und danach die Oberseite in dem nicht abgedeckten Zustand der Kontaktflächen dem maschinellen Lötvorgang unterworfen wird.

Eine vorteilhafte Weiterbildung der Erfindung besteht darin, dass die Ummantelung aus Graphitlack besteht, der auf die Kontaktfläche beispielsweise im Siebdruckverfahren oder durch Anwendung eines Lackspritzverfahrens unter Verwendung einer Schablone aufgebracht werden kann.

Weiterhin ist die Anwendung des Verfahrens gemäss den Patentansprüchen 1, 2 oder 3 auch dann besonders vorteilhaft, wenn auf der Oberseite der Leiterplatte ein Potentiometer angebracht werden soll. Entsprechend dem Patentanspruch 4 befinden sich sowohl dessen Widerstandsbahn als auch dessen Leiterbahn direkt auf der Oberseite der Leiterplatte, wobei die Leiterbahn wiederum mit einer Ummantelung gemäss Anspruch 1 oder 2 versehen wird. Der bewegliche Teil des Potentiometers besteht dabei aus einem in eine Lagerbohrung der Leiterplatte einsetzbaren Kontaktschleifer.

Zwar sind aus der FR-A-2 308 174 bereits mehrere Ausführungsformen eines Potentiometers bekannt, bei denen der an der Schleiferfeder des Potentiometers angebrachte, dessen Widerstandsbahn berührende und tropfenförmig ausgebildete Kontakt aus einem Lack-Russ-Gemisch besteht, welches ebenfalls die Eigenschaft besitzt, leitfähig, korrosionsbeständig, lotabweisend und selbstschmierend zu sein. Ein derartiges Potentiometer kann jedoch nur in üblicher Weise durch Hindurchführen seiner Anschlüsse zu den auf der Oberseite der Leiterplatte ausgebildeten Lötaugen auf der dem Lot nicht ausgesetzten Unterseite der Leiterplatte angebracht werden.

Der Gegenstand der Erfindung wird nachstehend anhand der Zeichnungen beispielsweise näher erläutert. Es zeigen:

Fig. 1 eine Querschnitt durch einen Ausschnitt aus einer Leiterplatte, die Lötaugen und mit Graphitlack ummantelte Leiterbahnabschnitte aufweist, und nach dem erfindungsgemässen Verfahren hergestellt sind.

Fig. 2 die Leiterplatte der Fig. 1 nach dem maschinellen Lötvorgang, deren Leiterbahnen zusammen mit einem Kontaktschleifer eine erste, nach dem erfindungsgemässen Verfahren hergestellte Kontaktvorrichtung bilden,

Fig. 3 die Leiterplatte der Fig. 2, bei der eine ihrer Leiterbahnen zusammen mit einem Federblechkontakt eine zweite, nach dem erfindungsgemässen Verfahren hergestellte Kontaktvorrichtung bilden und eine dritte, aus zwei Federblechen bestehende Kontaktvorrichtung, die mit der Leiterplatte mechanisch fest verbunden ist,

Fig. 4 eine als Teil eines Potentiometers ausgebildete Kontaktvorrichtung gemäss der Erfindung,

Fig. 5 dieselbe Kontaktvorrichtung in Draufsicht.

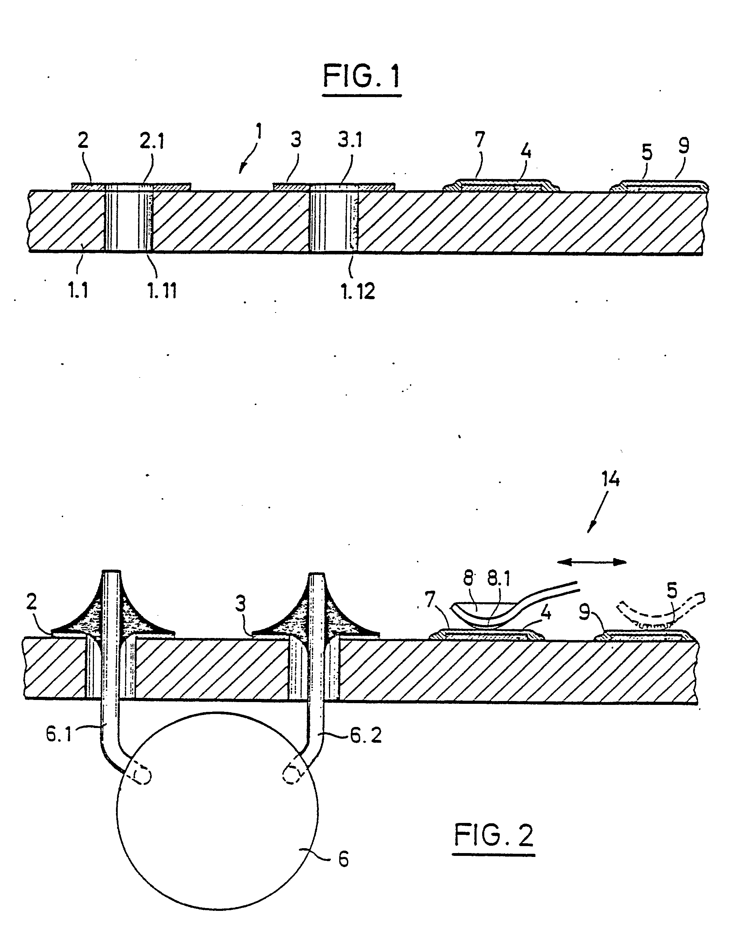

Die Fig. 1 lässt eine Leiterplatte 1 eines elektrischen Gerätes erkennen, deren Plattenkörper 1.1 in an sich bekannter Weise mit mehreren aus Kupferbahnen bestehenden Leitern 2, 3, 4 und 5 versehen ist, die bekanntlich die Aufgabe haben, den unterschiedlichen Bauelementen relativ schwache Ströme, insbesondere Steuerströme zuzuleiten.

Hierbei sind die im Querschnitt dargestellten Kupferbahnen 2 und 3 als Lötaugen ausgebildet und deshalb jeweils mit einer zentrischen Öffnung 2.1 und 3.1 versehen, die mit je einer Bohrung 1.11 und 1.12 des beispielsweise aus Hartpapier bestehenden Plattenkörpers 1.1 fluchtet. Diese Lötaugen dienen zum festen Verbinden eines elektronischen Bauteils, beispielsweise einer Diode 6 (Fig. 2) mit den Kupferbahnen 2 und 3. Zu diesem Zweck werden die beiden Zuleitungen 6.1 und 6.2 der Diode 6 durch die Bohrungen 1.11 und 1.12 des Plattenkörpers 1.1 hindurchgesteckt, so dass ihre Enden in die Lötaugen 2.1 und 3.1 der Kupferbahnen 2 und 3 eintauchen. Sodann werden diese durch Verlöten mit den Kupferleitern elektrisch und mechanisch verbunden.

Die mit den Kupferbahnen 2 und 3 der Leiterplatte verlöteten Zuleitungen 6.1 und 6.2 der Diode 6 zeigt die Figur 2. Das Verlöten geschieht hier im allgemeinen maschinell, beispielsweise nach dem Schlepplötverfahren, bei dem die gesamte Oberseite der Leiterplatte mit dem flüssigen Lötmittel in Berührung gebracht wird, wobei sämtliche Lötstellen in einem Arbeitsgang hergestellt werden.

Die Kupferbahnen 4 und 5 der in den Figuren 1 und 2 dargestellten Leiterplatte 1 dienen dagegen nicht dem Verlöten mit elektronischen Bauteilen. Sie sind hier vielmehr als Kontaktflächen einer nach dem erfindungsgemässen Verfahren hergestellten elektrischen Kontaktvorrichtung vorgesehen und dürfen somit, während des maschinellen Lötvorgangs, nicht mit Lot behaftet werden.

Gemäss vorliegender Erfindung sind deshalb die Kupferbahnen 4 bzw. 5 mit einer Ummantelung 7 bzw. 9 aus Graphitlack versehen, beispielsweise mit dem von der Firma Acheson Colloiden B.V., Postbus 1, 9679 ZG Scheemda, Holland, unter dem eingetragenen Warenzeichen «423SS» vertriebenen Graphitlack, der bei einer Temperatur von etwa 80 °C eine Trocknungszeit von etwa 30 Minuten benötigt.

Ein vollständiger Schutz der Kupferbahnen 4 und 5 vor anhaftendem Lot wird zuverlässig erreicht, wenn die Ummantelungen 7 und 9 auch die Seitenwände der Kupferbahnen 4 und 5 vollständig umgibt. Die Ummantelung der Kupferbahnen lässt sich, durch an sich bekannte Siebdruckverfahren oder auch durch Lackspritzverfahren und der Verwendung einer Schablone, relativ einfach herstellen.

Die Fig. 2 zeigt schematisch einen Kontaktschleifer 8 einer Kontaktvorrichtung 14, dessen Kontaktfläche ebenfalls mit einer Ummantelung 8.1 aus Graphitlack versehen ist. Diese Ummantelung ist noch einfacher herzustellen, als die der Leiterbahnen, da neben den bereits genannten Verfahren beispielsweise auch die Tauchlackier-Methode angewendet werden kann.

Der Kontaktschleifer 8 kann in den in der Fig. 2 durch einen Doppelpfeil gekennzeichneten Richtungen bewegt werden und kann so in eine erste Endlage, bei der er elektrisch mit der Leiterbahn 4 verbunden ist und in eine zweite Endlage, bei der er mit der Leiterbahn 5 elektrisch verbunden ist gelangen. Auf diese Weise können im Antriebs- oder Steuerstromkreis des elektrischen Gerätes einzelne Bauelemente oder Gruppen von Bauelementen angesteuert oder abgekoppelt werden.

Die Graphitschichten 7 und 9 besitzen selbstschmierende Eigenschaften, womit sich das bei Verwendung von metallbeschichteten Kontaktflächen erforderliche, periodisch zu wiederholende Einfetten der Gleitbahn erübrigt.

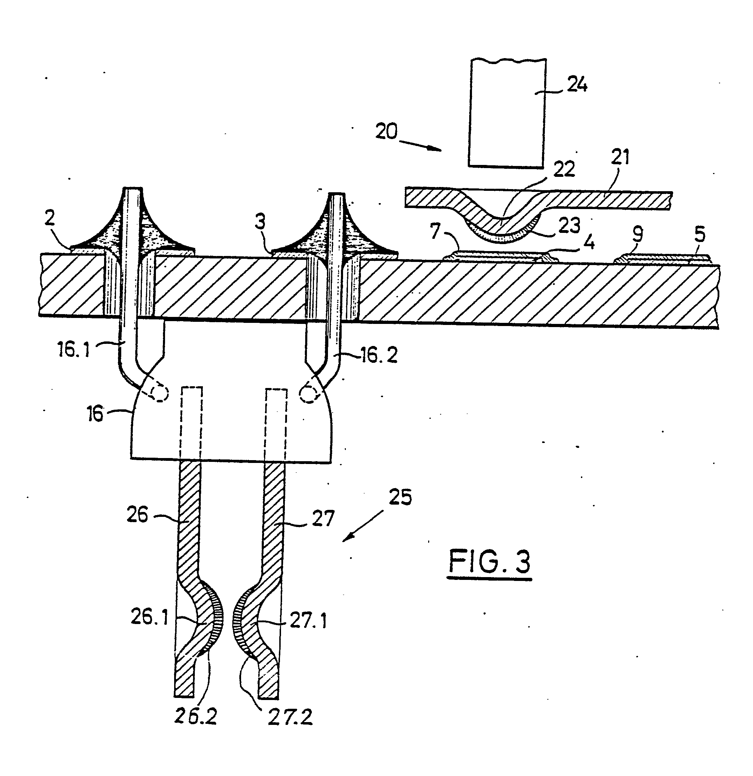

Bei den beiden in Fig. 3 dargestellten Ausführungsbeispielen (20, 25) einer nach dem erfindungsgemässen Verfahren hergestellten Kontaktvorrichtung handelt es sich um Kontaktvorrichtungen, deren Kontakte in der abgebildeten Ruhelage nicht geschlossen sind und erst durch Betätigen eines Hebels oder dergleichen geschlossen werden. Solche zum Beispiel mit Leiterplatten von elektrischen Kleingeräten zusammenwirkende Kontaktvorrichtungen findet man unter anderem bei batteriebetriebenen Uhren mit elektro-optischer Anzeige, bei denen aus Gründen der Stromersparnis die Uhrzeit nur bei Betätigen einer Taste oder dergleichen angezeigt wird.

Die rechts oben in der Fig. 3 dargestellte Kontaktvorrichtung (20) besteht im wesentlichen aus einem Federblech 21, welches eine gewölbte, mit einer Ummantelung 23 aus Graphitlack versehene Kontaktfläche 22 aufweist, dem Leiterbahnabschnitt 4, dessen Ummantelung 7 und einem schematisch dargestellten Betätigungshebel 24. Das Federblech 21 kann beispielsweise mechanisch fest mit dem Gehäuse des elektrischen Kleingeräts und elektrisch mit dessen Stromversorgung verbunden sein. Der Betätigungshebel 24, bei dessen Niederdrücken die mit einer Ummantelung 7 versehene Leiterbahn 4 dann mit der Stromversorgung verbunden ist, kann in einer hier nicht gezeichneten Ausnehmung des Gehäuses geführt und mit einer Drucktaste versehen sein.

Die links unten in der Fig. 3 dargestellte Kontaktvorrichtung 25 weist zwei Federbleche 26 und 27 auf, deren Kontaktflächen 26.1 und 27.1 mit einer Ummantelung (26.2, 27.2) aus Graphitlack überzogen sind. Beide Federbleche sind mit einer Halterung 16 mechanisch fest verbunden, die beispielsweise aus Kunststoff bestehen kann, in den die Federbleche eingegossen sind. Die Halterung 16 weist zwei starre Zuleitungen 16.1 bzw. 16.2 auf, die mit den Federblechen 26 bzw. 27 elektrisch verbunden und in den Lötaugen 2 bzw. 3 der Leiterplatte verlötet sind. Zur weiteren Stabilisierung der mechanischen Verbindung zwischen der Leiterplatte und den beiden Federblechen 26 und 27 kann die Halterung 16 eine hier nicht gezeichnete Nase aufweisen, die mit einer entsprechenden Ausnehmung in der Leiterplatte zusammenwirkt. Auch bei der Kontaktvorrichtung 25 können, durch Niederdrücken eines hier nicht dargestellten Betätigungshebels die beiden Kontaktflächen 26.1 und 27.1 miteinander in Berührung gebracht und damit ein Schaltvorgang ausgelöst werden.

Die links unten in der Fig. 3 abgebildete Kontaktvorrichtung, die keine in eine Leiterplatte integrierte Kontaktfläche mehr aufweist, braucht auch mechanisch nicht mit derselben verbunden sein, sondern kann an beliebiger Stelle des elektrischen Geräts angebracht sein.

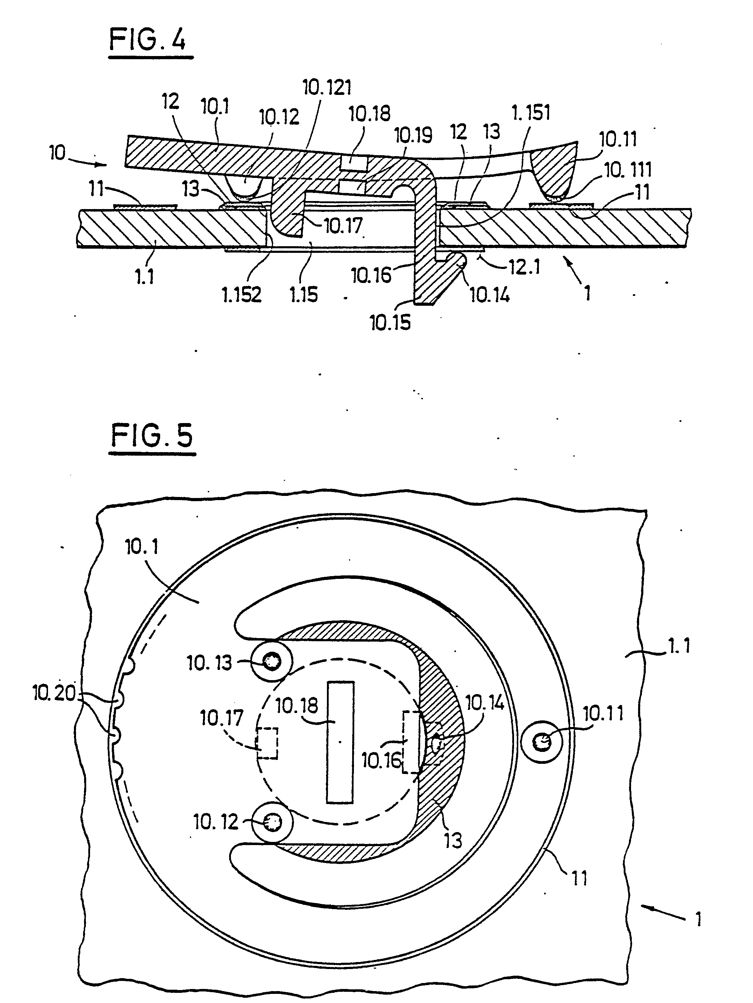

Ein Ausführungsbeispiel einer erfindungsgemässen Kontaktvorrichtung ist in den Figuren 4 und 5 dargestellt. Bei diesem Ausführungsbeispiel sind wiederum Kontaktflächen der Kontaktvorrichtung Bestandteil einer Leiterplatte, die mit weiteren Kontaktflächen der Kontaktvorrichtung so zusammenwirkt, dass ein teilweise in eine Leiterplatte integriertes Potentiometer entsteht. Auch bei diesem Ausführungsbeispiel sind die lotabweisenden und selbstschmierenden Eigenschaften von aus Graphitlack bestehenden Ummantelungen von wesentlicher Bedeutung.

Wie die Figur 4 erkennen lässt, besteht der in die Leiterplatte 1 integrierte Bestandteil des Potentiometers 10 aus einer sogenannten Widerstandsbahn 11, einer Leiterbahn 12 und einer kreisringförmigen Schicht 12.1 aus Graphitlack. Die Leiterbahn 12 und die Schicht 12.1 können einen geschlossenen Kreisring bilden, während die Widerstandsbahn 11 aus einem Kreisring-Ausschnitt besteht. Der bewegliche, also der drehbare Teil des Potentiometers 10 besteht hier aus einem Kontaktschleifer 10.1.

Die Leiterbahn 12 ist mit einer Ummantelung 13 aus Graphitlack versehen und daher lotabweisend, während die ebenfalls lotabweisende Widerstandsbahn 11 zum Beispiel aus einer im Siebdruckverfahren auf die Leiterplatte 1 aufgebrachten Widerstandspaste besteht. Der Kontaktschleifer 10.1 besteht hier aus einem einzigen Körper aus elektrisch leitendem Material mit grosser Biegeelastizität. Eine ihm angeformte Kontaktwarze 10.11, die mit einer Ummantelung 10.111 aus Graphitlack versehen ist, gleitet selbstschmierend auf der Widerstandsbahn 11. Zwei weitere ebenfalls dem Kontaktschleifer 10.1 angeformte Kontaktwarzen 10.12 bzw. 10.13 gleiten selbstschmierend auf der Ummantelung 13 der Leiterbahn 12 und weisen selbst auch Ummantelungen 10.121 und 10.131 aus Graphitlack auf (in der Figur 4 ist nur die Ummantelung 10.121 sichtbar).

Einer den Leiterplattenkörper 1.1 untergreifenden Schulter 10.15, die einem etwa rechtwinklig zur Leiterplattenebene sich erstreckenden, eine Lagerbohrung 1.15 der Leiterplatte 1 durchdringenden Segment 10.16 zugehört, ist eine Nase 10.14 angeformt. Ein weiteres etwa rechtwinklig zur Schleiferebene sich erstreckendes Segment 10.17 des Kontaktschleifers 10 liegt an dem (gemäss Fig. 4) linken Wandungsabschnitt 1.152 der Lagerbohrung 1.15 der Leiterplatte 1 an. Beide Segmente 10.16 bzw. 10.17 bilden im Zusammenwirken mit dem rechten bzw. linken Wandungsabschnitt 1.151 bzw. 1.152 der Lagerbohrung 1.15 somit eine ausreichende Lagerung des Kontaktschleifers 10.1 innerhalb der Lagerbohrung 1.15. Die auf der Graphitlack-Schicht 12.1 selbstschmierend gleitende Nase 10.14 ist so bemessen, dass sie im Zusammenwirken mit den Rückstellkräften des federnden Kontaktschleifers 10.1 für dessen axiale Sicherung und für eine Dreipunktauflage der Kontaktwarzen 10.11, 10.12 und 10.13 auf der Leiterbahn 12 bzw. der Widerstandsbahn 11 sorgt. Der Kontaktschleifer 10.1 ist vorteilhaft aus einer entsprechend gestalteten Blattfeder aus gut leitendem Material, beispielsweise Messing gebildet. Er kann jedoch nach einem weiteren Merkmal der Erfindung ebenso aus elektrisch leitfähigem, thermoplastischem Kunststoff mit guten Federeigenschaften und guter Abriebfestigkeit bestehen.

Zum Verdrehen des Kontaktschleifers 10.1 gegenüber der Leiterplatte 1 sind dem Schleifkörper Stellschlitze 10.18 und 10.19 angeformt, in die ein Schlüssel oder ein Werkzeug (beispielsweise Schraubenzieher) sowohl von der Oberseite als auch von der Unterseite der Leiterplatte eingeführt werden kann. Dem gleichen Zweck dienen am Umfang des Kontaktschleifers 10.1 vorgesehene Steckausschnitte 10.20, die bei beschränkter Zugänglichkeit des Potentiometers das schrittweise Verdrehen des Kontaktschleifers 10.1 durch stetiges Umsetzen eines geeigneten Schlüssels von Ausschnitt zu Ausschnitt ermöglichen.

In den Figuren 4 und 5 sind die drei, bei Potentiometern üblichen elektrischen Anschlüsse, nämlich ein Anschluss an einem Ende und ein Anschluss am anderen Ende der Widerstandsbahn 11, zwischen denen der gesamte Widerstand der Widerstandsbahn 11 anliegt und ein Anschluss an der Leiterbahn 12 zum Abgriff des von der Stellung des Kontaktschleifers abhängigen Widerstands nicht eingezeichnet.

Die Anwendungen des erfindungsgemässen Verfahrens sind nicht auf die vorstehend beschriebenen Ausführungsbeispiele beschränkt, vielmehr kann die erfindungsgemässe Ummantelung von Kontaktflächen mit preiswertem und einfach aufzubringendem Graphitlack aufgrund seiner lotabweisenden und selbstschmierenden Eigenschaften in vielen weiteren elektrischen Kontaktvorrichtungen vorteilhaft angewendet werden. Ebenso kann anstelle des genannten Graphitlacks der Firma Acheson jeder andere Graphitlack oder ein anderes Material für die Ummantelung der Kontaktflächen verwendet werden, sofern es hinsichtlich elektrischer Leitfähigkeit und Korrosionsbeständigkeit vergleichbar ist und lotabweisende und selbstschmierende Eigenschaften aufweist.

**Patentansprüche**

1. Verfahren zur Herstellung eines mit elektrischen Bauteilen, deren Anschlüsse maschinell in Lötaugen verlötet werden, bestückten Leiterplatte, die auf ihrer dem Lot ausgesetzten Oberseite Leiterbahnen und Kontaktflächen aufweist, wobei letztere jeweils aus einem Teilabschnitt einer Leiterbahn bestehen, dadurch gekennzeichnet, dass die Kontaktflächen (4, 5, 12) der Oberseite mit einer lotabweisenden, aber elektrisch leitfähigen, korrosionsbeständigen und selbstschmierenden Ummantelung (7, 9, 13) versehen werden und danach die Oberseite im nicht abgedeckten Zustand der Kontaktflächen dem maschinellen Lötvorgang unterworfen wird.

2. Verfahren nach Anspruch 1, dadurch gekennzeichnet, dass die Ummantelung aus Graphitlack besteht.

3. Verfahren nach Anspruch 2, dadurch gekennzeichnet, dass die Ummantelungen (7, 9, 13) aus Graphitlack auf die Kontaktflächen (4, 5, 12) auf der Oberseite der Leiterplatte (1) im Siebdruckverfahren oder durch Anwendung eines Lackspritzverfahrens unter Verwendung einer Schablone aufgebracht werden.

4. Kontaktvorrichtung, die aus einer nach dem Verfahren gemäss Anspruch 1 oder 2 hergestellten, eine Kontaktfläche aufweisenden Leiterplatte und aus mindestens einer Gegenkontaktfläche besteht, dadurch gekennzeichnet, dass die Kontaktfläche (12) kreisringförmig ausgebildet ist, dass die Gegenkontaktfläche (10.12, 10.13) der Kontaktvorrichtung Teil eines Kontaktschleifers (10.1) ist, der einstückig ausgebildet und zugleich bewegliches Teilstück eines Potentiometers (10) ist, dessen unbeweglicher Teil von der kreisringförmigen Kontaktfläche (12) und einer dazu konzentrisch angeordneten, nicht geschlossenen Widerstandsbahn (11) ausgebildet wird.

5. Kontaktvorrichtung nach Anspruch 4, dadurch gekennzeichnet, dass der Kontaktschleifer (10.1) des Potentiometers (10) gebildet ist aus einem kreisförmigen, federnden Schleiferkörper, der Kontaktwarzen (10.13, 10.12 bzw. 10.11) mit einer Ummantelung (10.131, 10.121 bzw. 10.111) gemäss Anspruch 1 oder 2 aufweist, die auf der Ummantelung (13) der Kontaktfläche (12) bzw. auf der Widerstandsbahn (11) selbstschmierend gleiten, und aus wenigstens zwei etwa rechtwinklig von der Schleiferebene abgebogenen, in eine zentrische Ausnehmung (1.15) der Leiterplatte eingreifenden Lagersegmenten (10.16, 10.17), von denen zumindestens einem Segment (10.16) eine die Leiterplatte untergreifende Schulter (10.15) angeformt ist.

6. Kontaktvorrichtung nach Anspruch 5, dadurch gekennzeichnet, dass auf der Unterseite des Leiterplattenkörpers (1.1) eine die Ausnehmung (1.15) ringförmig umgebende Schicht (12.1) aufgebracht ist, auf der eine der Schulter (10.15) angeformte Nase (10.14) selbstschmierend gleitet, die so bemessen ist, dass durch die vom Kontaktschleifer ausgeübte Biegespannung dessen axiale Sicherung und eine Dreipunktauflage der Kontaktwarzen erreicht wird.

7. Kontaktvorrichtung nach Anspruch 5 oder 6, dadurch gekennzeichnet, dass der Kontaktschleifer (10.1) des Potentiometers (10) aus einem elektrisch leitfähigen thermoplastischen Kunststoff mit guter Dauerfedereigenschaft besteht.

**Claims**

1. Process for producing a printed board assembly with electrical components whose terminals are mechanically soldered in eyelets and whose top surface exposed to the solder has printed conductors and contact surfaces, the latter in each case comprising a portion of a printed conductor, characterized in that the contact surfaces (4, 5, 12) of the top side are provided with a solder-repellent, but electrically conductive, corrosion-resistant and self-lubricating coating (7, 9, 13) and then the top surface in the uncovered state of the contact surfaces is subject to the mechanical soldering process.

2. Process according to claim 1, characterized in that the coating is formed from graphite-based lacquer.

3. Process according to claim 2, characterized in that the graphite-based lacquer coatings (7, 9, 13) are applied to the contact surfaces (4, 5, 12) on the top of the printed board assembly (1) by the screen printing process or by using a lacquer spraying process with a stencil.

4. Contact means comprising a printed board assembly having a contact surface produced according to the process of claims 1 or 2 and at least one opposite contact surface, characterized in that the contact surface (12) is circular ring shaped, that the opposite contact surface (10.12, 10.13) of the contact means forms part of a contact slider (10.1), which is constructed in one piece and simultaneously forms a movable portion of a potentiometer (10), whose fixed part is formed by the circular ring shaped contact surface (12) and a not closed resistor run (11) arranged concentrically thereto.

5. Contact means according to claim 4, characterized in that the contact slider (10.1) of potentiometer (10) is formed from a circular, resilient slider member, which has contact bosses (10.13, 10.12 or 10.11) with a coating (10.131, 10.121 or 10.111) according to claim 1 or 2, which slide in self-lubricating manner on the coating (13) of contact surface (12) or on the resistor run (11) and comprise at least two bearing segments (10.16, 10.17) bent down approximately at right angles from the slider plane and engaging in a central recess (1.15) of the printed board assembly, a shoulder (10.15) engaging below the printed board assembly being shaped onto at least one segment (10.16).

6. Contact means according to claim 5, characterized in that a layer (12.1) surrounding in annular manner the recess (1.15) is applied to the bottom of the printed board body (1.1) and on said layer slides in self-lubricating manner a nose (10.14) shaped onto shoulder (10.15) and which is dimensioned in such a way that as a result of the bending stress experted by the contact slider, it is axially secured and there is a three-point bearing of the contact bosses.

7. Contact means according to claim 5 or 6, characterized in that the contact slider (10.1) of potentiometer (10) is formed from an electrically conductive thermoplastic material with good permanent springiness characteristics.

**Revendications**

1. Procédé de fabrication d'une carte à circuit imprimé équipée de composants électriques dont les bornes sont mécaniquement soudées dans des pastilles de soudage, cette carte présentant, sur sa face supérieure exposée à la soudure, des pistes conductrices et des surfaces de contact, ces dernières étant constituées chacune d'une portion d'une piste conductrice, caractérisé en ce que les surfaces de contact (4, 5, 12) de la face supérieure sont munies d'un revêtement (7, 9, 13) repoussant la soudure mais électriquement conducteur, résistant à la corrosion et autolubrifiant, après quoi la face supérieure est soumise au soudage mécanique alors que les surfaces de contact sont à l'état non recouvert.

2. Procédé selon la revendication 1, caractérisé en ce que le revêtement est en laque au graphite.

3. Procédé selon la revendication 2, caractérisé en ce que les revêtements (7, 9, 13) en laque au graphite sont appliqués sur les surfaces de contact (4, 5, 12), sur la face supérieure de la carte à circuit imprimé (1), par sérigraphie ou par utilisation d'un procédé de pulvérisation de laque en utilisant un pochoir.

4. Dispositif de contact, constitué par une carte à circuit imprimé présentant une surface de contact réalisée par le procédé selon la revendication 1 ou 2, et par au moins une surface de contact conjuguée, caractérisé en ce que la surface de contact (12) est réalisée en forme de couronne circulaire, en ce que la surface de contact conjuguée (10.12, 10.13) du dispositif de contact fait partie d'un curseur de contact (10.1) qui est réalisé d'une seule pièce et qui est en même temps la pièce mobile d'un potentiomètre (10) dont la partie non-mobile est constituée par la surface de contact (12) en forme de couronne circulaire et par une piste-résistance (11) disposée concentriquement à celle-ci et non fermée.

5. Dispositif de contact selon la revendication 4, caractérisé en ce que le curseur de contact (10.1) du potentiomètre (10) est formé d'un curseur de frottement élastique de forme circulaire, qui présente des boutons de contact (10.13, 10.12, 10.11) avec un revêtement (10.131, 10.121; 10.111) selon la revendication 1 ou 2, lesquels boutons de contact glissent de manière autolubrifiante sur le revêtement (13) de la surface de contact (12) ou, selon le cas, sur la piste-résistance (11), et sont constitués par au moins deux segments de palier (10.16, 10.17), lesquels sont coudés à peu près à 90° depuis le plan du curseur et s'engagent dans un évidement centré (1.15) de la carte à circuit imprimé, un épaulement (10.15) qui vient se placer sous la carte à circuit imprimé étant formé à partir d'au moins l'un (10.16) de ces segments.

6. Dispositif de contact selon la revendication 5, caractérisé en ce que sur la face inférieure du corps (1.1) de la carte à circuit imprimé est appliquée une couche (12.1) qui entoure annulairement l'évidement (1.15) et sur laquelle un bec (10.14) formé sur l'épaulement (10.15) glisse de manière autolubrifiante, ce bec étant dimensioné de façon que la contrainte de flexion exercée par le curseur de contact permette d'obtenir l'arrêt axial de celui-ci et un appui sur trois points des boutons de contact.

7. Dispositif de contact selon la revendication 5 ou 6, caractérisé en ce que le curseur de contact (10.1) du potentiomètre (10) est constitué par une matière thermoplastique électriquement conductrice ayant des caractéristiques d'élasticité permanente.

0 076 292

## FIG. 1

## FIG. 2

7

FIG. 3

FIG. 4

FIG. 5